# EUROPEAN PATENT SPECIFICATION

(11) **EP 0 388 523 B1**
(45) Date of publication and mention of the grant of the patent: **09.02.1994**
(21) Application number: 89121901.6
(22) Date of filing: 28.11.1989
(51) Int. Cl.: H02J 7/00, G01R 31/36

(54) **Apparatus for displaying residual capacity of battery**
Anordnung zum Anzeigen der Restladung eines Akkumulators
Appareil pour afficher la capacité résiduelle d'une batterie

(30) Priority: 20.03.1989 JP 68280/89
(43) Date of publication of application: 26.09.1990
(73) Proprietor: SUZUKI MOTOR CORPORATION, Shizuoka-ken (JP)
(72) Inventor: Shibata, Akira, Hamana-gun Shizuoka-ken (JP)
(74) Representative: Klingseisen, Franz, Dipl.-Ing.

(56) References cited:
- EP-A- 0 225 106
- GB-A- 2 116 728
- US-A- 3 940 679

## Description

### [Industrial Field of Utilization]

The present invention relates to an apparatus for displaying a residual capacity of a battery and, more particularly, to a battery residual capacity display apparatus which is needed in the case where the battery charging and discharging operations are repetitively executed between electric motorcars or the like such as electric motor chairs.

### [Prior Art]

As battery residual amount measuring instruments which have been used hitherto, there have been known a simple voltmeter as the simplest one and a voltmeter to enlargely display a partial indicating range. On the other hand, there has been known an instrument such that the consumed current amount is obtained and added (accumulated) or subtracted from a predetermined value, thereby obtaining a residual amount. EP-A-225106 discloses such an instrument which also measures the battery voltage and temperature to take into account the effects of varying temperatures, and to reset the calculated residual capacity value to 0 resp. 100% when the battery voltage has reached either a predetermined minimum or maximum value.

On the other hand, in the case of the voltmeter type, a terminal voltage of the battery largely fluctuates due to a fluctuation of a load and is extremely inaccurate in the cases other than the case where the battery is continuously discharged by a constant current value. Therefore, there is also a type in which a current value is fed back to thereby correct the input voltage to the measuring instrument.

### [Subjects that the Invention is to solve]

In the case of the voltmeter type among the conventional battery residual amount measuring instruments, since a voltage fluctuation due to the load is large as mentioned above, its display value is generally nothing but an approximate value.

On the other hand, in the case of the current amount calculating type, although the value is accurate, the apparatus is expensive and it is difficult to discriminate the present discharge amount and the correction based on the temperature is normally not executed.

The type in which the current value is fed back and the detection voltage value is corrected can also perform the temperature correction and has a fairly high reliability. However, there are problems such that the apparatus cannot follow a steep frequent fluctuation and the characteristics of the voltage change to the discharge amount are not linear, so that errors easily occur.

### [Object of the Invention]

It is an object of the present invention to solve the subjects of such a conventional technique and to provide an apparatus for displaying a residual capacity of a battery in which although it is of the voltage display type, the display is stable and the accuracy is high and a display value in which an influence by a temperature was compensated is obtained.

### [Means of Solving the Subjects]

The invention comprises a voltage input section to input voltage value data of a battery, a current input section to input data of a discharge current value of the battery, and a temperature input section to input data of a temperature value. The invention has a plurality of data tables, each for a designated temperature range, for dividing the voltage values of the battery into a predetermined plurality of levels corresponding to a discharge current value range and a first CPU and a data processing section for outputting a signal to indicate by the levels the voltage value indicative of the residual amount of the battery which was corrected by the discharge current value by using the data tables. The invention has a meter section for processing an output of the data processing section and for displaying the levels. The data processing section has a data fetching function for fetching the current data of the current input section at intervals having a first predetermined time or longer and, when the data is within a predetermined range and also lies within such a range for a time which is equal to or longer than a second predetermined time shorter than the first predetermined time, for fetching the voltage data of the voltage input section and the temperature data of the temperature input section and for fetching the data table corresponding to a temperature range including the temperature data and a voltage display control function for obtaining the number of levels corresponding to the current range including the current data and to the voltage data on the basis of those data and, when such a number differs from the number upon previous processing by two or more levels, for compressing the difference from the previous number into one level and displaying to the meter section. Due to this, the above object is accomplished.

### [Embodiment of the Invention]

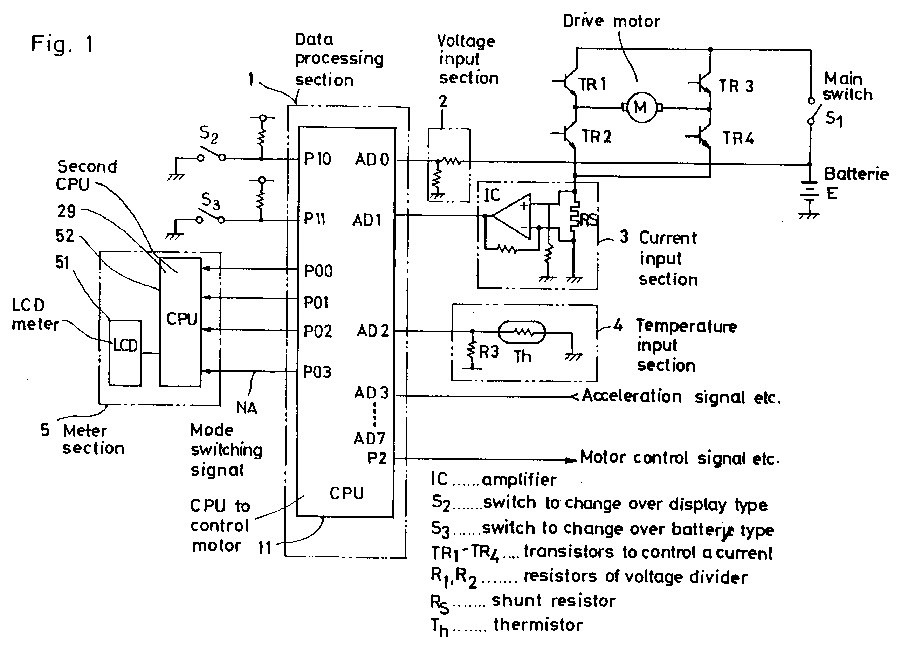

An embodiment of the present invention will be described hereinbelow on the basis of Figs. 1 to 7.

In a battery residual amount display type to display a residual capacity of a battery by a voltage of the battery, an embodiment shown in Figs. 1 to 7 comprises:
a data processing section 1; and a voltage input section 2, a current input section 3, a temperature input section 4, and a meter section 5 which are arranged in parallel with the data processing section 1. The current data of the current input section 3 is fetched at an interval of a first predetermined time or longer. When the current data is within a predetermined range, such data is fetched. On the other hand, when the data lies within such a range for a time which is equal to or longer than a second predetermined time shorter than the first predetermined time, the voltage data of the voltage input section 2 and the temperature data of the temperature input section 4 are fetched. A data table 12 corresponding to a temperature range including the temperature data is fetched. When the level of the voltage value corresponding to the current range including the current data and the voltage data differs from the level upon previous processing by two or more levels, the difference between those levels is compressed into one level and displayed to the meter section 5.

The data processing section 1 has a plurality of data tables 12 for dividing the voltage value of the battery corresponding to the discharge current value range into a plurality of levels and for specifying every predetermined temperature range. A first CPU 11 generates an output to display by the level the voltage value indicative of the residual amount of the battery which was corrected by the discharge current value by using the data tables 12.

The voltage input section 2 detects the voltage value of the battery and inputs the data to the data processing section 1.

The current input section 3 detects the discharge current value of the battery and inputs the data to the data processing section 1.

The temperature input section 4 detects the temperature value of the battery and inputs the data to the data processing section 1.

The meter section 5 has a meter 51 to display every level. A second CPU 52 processes the output of the data processing section 1 and displays to the meter 51.

This will be further explained in detail. When a main switch S₁ is on, a drive current is supplied from a battery E to a drive motor M of an electric motorcar through current controlling transistors TR₁ to TR₄ by, for instance, the chopping control. Thus, the motor rotates and drives the electric motorcar.

The data processing section 1 has a CPU 11 to control the motor M and executes a data process to display the residual amount of the battery by using a part of the functions of the CPU. An acceleration signal and the like to control the motor M are input to ports AD3 to AD₇ of the CPU 11. In addition, signals such as a control signal and the like for the motor M are output from a port P₂.

The voltage input section 2 has a voltage divider comprising resistors R₁ and R₂ and gives a voltage input of the battery E to a port AD₀ of the CPU 11.

The current input section 3 has a shunt resistor Rₛ for allowing a motor current to flow and an amplifier IC to amplify the generating voltage and gives a current input of the battery E to a port AD₁ of the CPU 11.

The temperature input section 4 has a thermistor Tₕ and gives a temperature input to a port AD₂ of the CPU 11 by the generating voltage when a current is supplied from a constant voltage V_{cc} through a resistor R₃.

In the embodiment, an LCD meter is used to display. Further, display data D₀ to D₂ are output from ports P₀₀ to P₀₂ of the CPU 11 and display mode switching data (N/A) is output.

A switch S₂ is connected to a port P₁₀ of the CPU 11 and gives a switching input between the correction display mode of the type according to the invention and the ordinary voltage display mode.

A switch S₃ is connected to a port P₁₁ of the CPU 11 and gives a switching input of a routine in the case where the battery type differs.

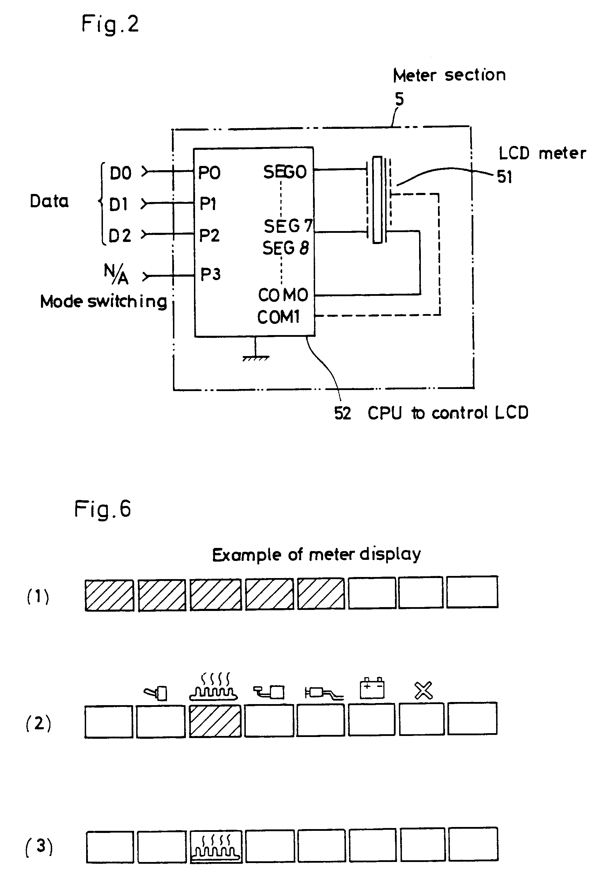

Fig. 2 shows an example of a construction of a circuit of the display meter. The LCD meter 51 and the CPU 52 to control the LCD meter are shown.

The CPU 52 to control the LCD meter has therein an LCD segment driver and receives the display data D₀ to D₂ and display mode switching data N/A from the data processing section 1 and outputs segment controlling data SEG₀ to GEG₇ of the LCD meter 51. The LCD meter 51 executes the visible display every segment by such data and input data COM₀ and COM₁ to two common electrodes.

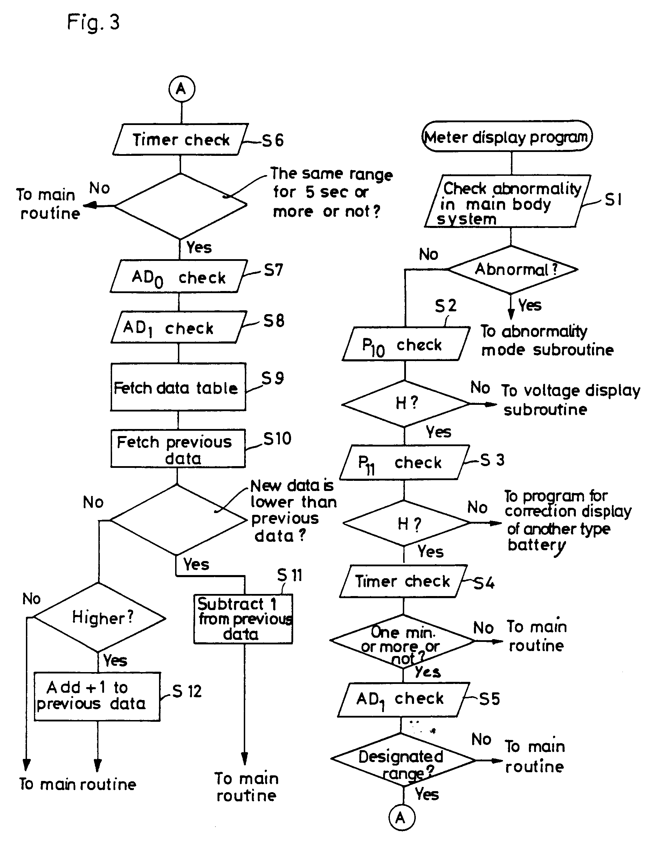

Fig. 3 is a flowchart showing a meter display process in the type of the invention.

The operation of the type of the invention will be described hereinbelow in accordance with the flow. The meter display program is a kind of subroutine and nay have a form of a multitask. Since this program is finished in a short time, no influence is exerted on the main program to control the motor.

First, a check is made to see if an abnormality has occurred in the main body system or not (step S₁). If an abnormality has occurred, the processing routine advances to the abnormal mode subroutine. If no abnormality occurs, the input of the port P₁₀ is checked (step S2) and the setting state of the switch S₂ is checked. If it is not at the high level ("H"), the processing routine advances to the ordinary voltage display subroutine. If it is at the high level, the input of the port P11 is checked (step S3) and the setting state of the switch S₃ is checked. lf it is not at the high level, the processing routine advances to a program for another type battery correction display. If it is at the high level, the internal timer is checked (step S4) and the elapse of a time from the previous process is checked. This is because if the time of one minute or longer from the previous data process does not elapse, the display of the meter is not updated.

If the time of one minute or longer has elapsed, the input of the port AD₁ is checked (step S5) and a check is made to see if the current value lies within a designated range or not.

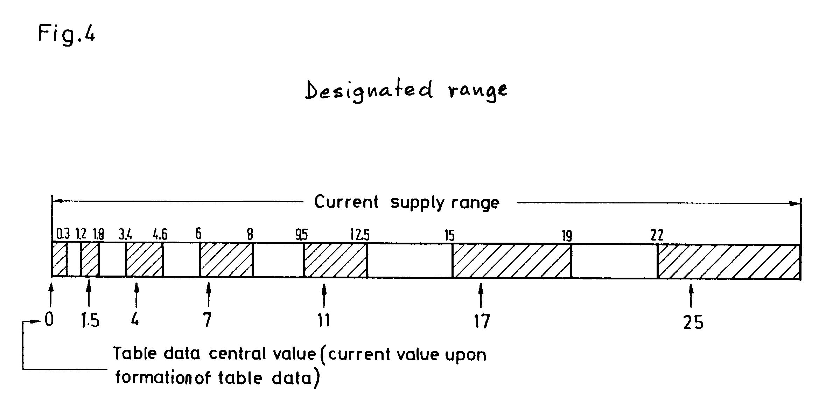

Fig. 4 shows the designated range of the current value correction. ln the current supply range, a hatched portion is a correction region shown by a current range. On the other hand, a numeral in the lower column indicates a central value of a table data, which will be explained hereinafter, and denotes a current value upon formation of the data table.

When the current value does not lie within the designated range, the processing routine immediately advances to the main routine. lf it lies within the designated range, the timer is again checked (step S6). The fluctuating state of the current value is checked by checking whether the current value falls within the designated range for five seconds or longer or not. In this case, the presence or absence of the fluctuation is discriminated by checking the data stored in a memory (RAM) of the CPU 11. However, actually, it is discriminated by checking whether the levels which were instantaneously checked lie within the designated range or not a few times or more (it is better as the number of checking times is large) for five seconds. If the level is out of the region during such an interval, the processing routine advances to the main routine, the motor control process is executed, and upon completion of such a process, the meter display program is executed.

If the designated range has continued for five seconds or longer, the port AD₀ is checked (step S7) and the voltage value is checked and the port AD₂ is checked (step S8) and the temperature value is checked. The internal data table 12 corresponding to the input data of the current range, voltage range, and temperature range is fetched (step S9). The value of the data table changes depending on the temperature data. If the temperature data range is narrow, the accuracy is improved due to it. However, since a data amount increases, the practical accuracy range is held. ln the embodiment, the range is divided into seven regions.

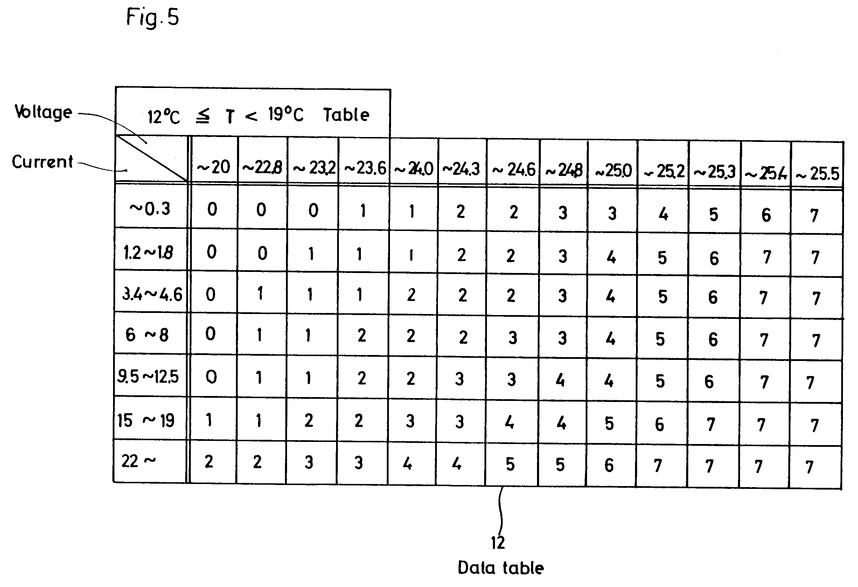

Fig. 5 shows an example Of the data table 12 and indicates the display data (0 to 7) for the current and voltage values in the designated temperature range 12 [°C] ≦ T < 19 [°C] (T denotes a temperature) when the read temperature is 15 [°C]. Each data is displayed by the hexadecimal notation.

Further the previous data is fetched (step S10). A check is made to see if the new data is lower than the previous data or not. If it is lower than the previous data, "1" is subtracted from the previous data (step S11) and the main routine follows. If it is not lower than the previous data, a check is made to see if it is higher than the previous data or not. If it is not higher than the previous data, this means that the new data has the same value as the previous data. Therefore, the processing routine directly advances to the main routine. If it is higher than the previous data, "1" is added to the previous data (step S12) and the main routine follows.

For instance, in Fig. 5, when the current lies within a range from 3.9 to 4.4 [A] and the battery voltage at this time is set to 23.9 [V], the fetched data is "2". However, in this case, if the previous data is "4", "3" is displayed.

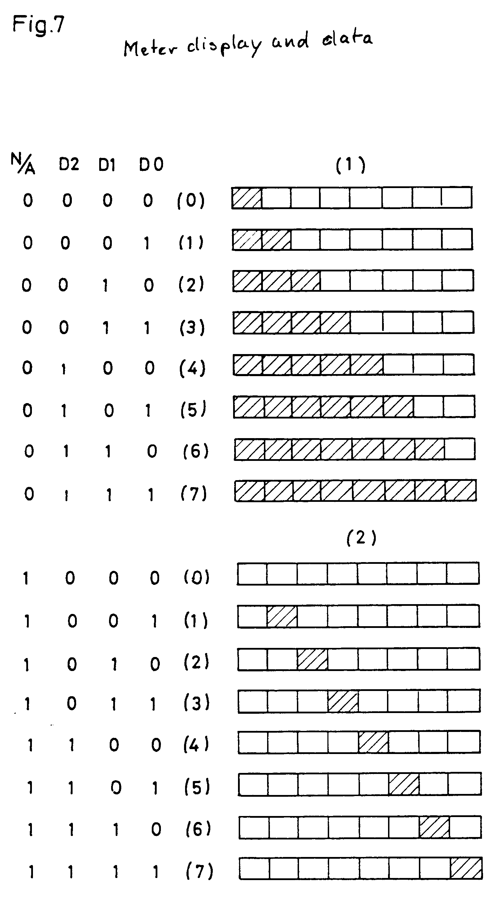

Fig. 6 shows an example of the display of the LCD meter 51 shown in Fig. 2. Fig. 6(1) shows the case where the apparatus is used commonly with the ordinary battery level meter. The voltage display in the normal mode and the correction display of the type of the invention are executed. The diagram shows the case where "4" is displayed in the case where the range is divided into eight levels of 0 to 7. Figs. 6(2) and 6(3) show the cases where the LCD meter 51 has two common electrodes and the display is executed in two layers and show examples upon abnormal display.

Among them, Fig. 6(2) shows an example of the case where the voltage display LCD is of the ordinary type and pictorial symbols are printed in the upper portion of the LCD and the abnormal content is displayed by flickering the black portion of the LCD. Although the ordinary characters may be used as pictorial characters in this case, by using the world common symbols, one kind of product can cope with the markets of the whole world.

Fig. 6(3) shows the case where the voltage display LCD itself can display the pictorial symbols.

Fig. 7 shows the input data of the meter circuit and the meter display corresponding thereto. Fig. 7(1) shows the case of the ordinary mode. By giving "0" as the mode switching data (N/A), data is displayed by all of the digits corresponding to 0 to 7 of the data D₂ to D₀. ( ) indicates the number of corresponding data table.

On the other hand, Fig. 7(2) shows the case of the abnormal mode. By giving "1" as the mode switching data (N/A), data is displayed by the highest digits corresponding to 0 to 7 of the data D₂ to D₀. In this case, "1000" is not used because it is easily confused with "0000" in the ordinary mode.

### [Effects of the Invention]

As described above, according to the invention, in an apparatus for displaying a residual amount (residual capacity) of the battery by the voltage, the display is stable and the accuracy is high and the display value in which an influence by the temperature was compensated can be obtained. That is, since the display level does not change unless at least one minute elapses, the display is stable. On the other hand, even if the data fluctuates by two or more levels due to the accumulation of some errors, the level always fluctuates by only one level each time, so that the display accuracy reliability rises. Further, since the data table which is used is switched in accordance with the temperature, the residual amount display accuracy can be improved. In this cases it is sufficient to input only the current and temperature data at an almost central point of the divided display region. Therefore, the memory capacity can be reduced.

On the other hand, according to the invention, since the meter display is stable, even if the multidisplay of the meter display and abnormal display is used, they can be easily observed and discriminated. Further, by switching of the switch, the apparatus can be also used as a voltmeter to merely display. Therefore, the apparatus can be used as a meter even in the case where the errors from the table data increased due to the deterioration of the battery or the like. On the other hand, by preparing two or more kinds of data tables and switching them by a switch, the apparatus can also cope with a plurality of kinds of batteries.

### 4. Brief Explanation of the Drawings

Fig. 1 is a diagram showing an embodiment of the present invention; Fig. 2 is a diagram showing an example of a circuit construction of a display meter; Fig. 3 is a flowchart showing a meter display process in the type of the invention; Fig. 4 is a diagram showing a designated range of the current value correction; Fig 5 is a diagram showing an example of a data table; Fig. 6 is a diagram showing an example of a meter display in the type of the invention; and Fig. 7 is a diagram showing input data of a meter circuit and a meter display for them.

1... data processing section, 2... voltage input section, 3... current input section, 4... temperature input section, 5... meter section, 11... CPU to control a motor, 12... data table, 51... LCD meters 52... CPU to control the LCD meter, S₁... main switch, S₂... switch to change over the display type, S₃... switch to change over the battery type, TR₁ to TR₄... transistors to control a current, R₁ and R₂... resistors of a voltage divider, Rₛ... shunt resistor, Rₕ... thermistor.

## Claims

1. An apparatus for displaying a residual capacity of a battery (E), comprising:
a voltage input section (2) to input a voltage value data of the battery (E); a current input section (3) to input data of a discharge current value of the battery (E); a temperature input section (4) to input data of a temperature value;
a plurality of data tables (12), each for a designated temperature range, for dividing the voltage values of the battery into a predetermined plurality of levels corresponding to a discharge current value range; a first CPU (11) and a data processing section (1) for outputting a signal to display by said levels the voltage value indicative of the residual amount of the battery (E) ← which was corrected by the discharge current value by using said data tables (12); and
a meter section (5) for processing an output of said data processing section (1) and for displaying said levels,
wherein said apparatus is characterized in that said data processing section (1) has a data fetching function for fetching the current data of the current input section (3) at intervals having a first predetermined time or longer and, when said data is within a predetermined range and also lies within said range for a time period which is equal to or longer than a second predetermined time shorter than said first predetermined time, for fetching both of the voltage data of said voltage input section (2) and the temperature data of said temperature input section (4), and for fetching the data table (12) corresponding to a temperature range including said temperature data and a voltage display control function for obtaining the number of levels corresponding to the current range including the current data and to the voltage data on the basis of those data and, when said number differs from the number upon previous processing by two or more levels, for compressing the difference from the previous number to one level and displaying the thus updated residual capacity corresponding to the number of levels to said meter section (5).

## Patentansprüche

1. Gerät zum Anzeigen einer Restladung einer Batterie (E), die folgendes aufweist:
einen Spannungseingabeabschnitt (2) zum Eingeben von Spannungswertdaten der Batterie (E); einen Stromeingabeabschnitt (3) zum Eingeben von Daten eines Entladestromwerts der Batterie (E); einen Temperatureingabeabschnitt (4) zum Eingeben von Daten eines Temperaturwerts;
eine Vielzahl von Datentabellen (12), von denen jede für einen bestimmten Temperaturbereich vorgesehen ist, zum Einteilen der Spannungswerte der Batterie in eine vorbestimmte Vielzahl von Pegeln entsprechend einem Entladestromwertbereich; eine erste CPU (11) und einen Datenverarbeitungsabschnitt (1) zum Ausgeben eines Signals, um durch die Pegel den Spannungswert anzuzeigen, der den Restbetrag der Batterie (E) anzeigt, der durch den Entladestromwert durch Benutzen der Datentabellen (12) korrigiert wurde; und
einen Meßinstrumentenabschnitt (5) zum Verarbeiten einer Ausgabe des Datenverarbeitungsabschnitts (1) und zum Anzeigen der Pegel,
wobei das Gerät dadurch gekennzeichnet ist, daß der Datenverarbeitungsabschnitt (1) eine Datenholfunktion aufweist zum Holen der Stromdaten des Stromeingabeabschnitts (3) bei Intervallen, die eine erste vorbestimmte Zeitspanne oder länger sind, und, wenn die Daten in einem vorbestimmten Bereich und auch in dem Bereich für eine Zeitperiode liegen, die gleich oder länger als eine zweite vorbestimmte Zeitspanne ist, die kürzer als die erste vorbestimmte Zeitspanne ist, zum Holen sowohl der Spannungsdaten des Spannungseingabeabschnitts (2) als auch der Temperaturdaten des Temperatureingabeabschnitts (4), und zum Holen der Datentabelle (12) entsprechend einem Temperaturbereich, der die Temperaturdaten und eine Spannungsanzeige-Steuerfunktion enthält, zum Erhalten der Anzahl von Pegeln entsprechend dem Strombereich, der die Stromdaten enthält, und entsprechend den Spannungsdaten auf der Basis jener Daten, und, wenn sich die Anzahl von der Zahl beim vorherigen Verarbeiten um zwei oder mehrere Pegel unterscheidet, zum Komprimieren der Differenz von der vorherigen Zahl zu einem Pegel und Anzeigen der derart auf den neuesten Stand gebrachten Restladung entsprechend der Anzahl von Pegeln an dem Meßinstrumentenabschnitt (5).

## Revendications

1. Appareil pour afficher la capacité résiduelle d'une batterie (E), comprenant :
- une partie entrée de la tension (2) pour introduire une donnée de la valeur de la tension de la batterie (E), une partie entrée du courant (3) pour introduire une donnée de la valeur du courant de décharge de la batterie (E), une partie entrée de la température (4) pour introduire une donnée de la valeur de la température;
- une pluralité de tables de données (12), chacune pour une gamme spécifiée de températures, pour diviser les valeurs de tension de la batterie en une pluralité prédéterminée de niveaux correspondant à une gamme de valeurs de courant de décharge, une première unité centrale de traitement (11) et une partie traitement des données (1) pour fournir en sortie un signal pour afficher par lesdits niveaux la valeur de tension indicatrice de la capacité résiduelle de la batterie (E), qui a été corrigée par la valeur du courant de décharge en utilisant lesdites tables de données (12); et
- une partie indicateur de mesure (5) pour traiter le signal de sortie de ladite partie traitement des données (1) et pour afficher lesdits niveaux,
ledit appareil étant caractérisé en ce que ladite partie traitement des données (1) a une fonction de lecture des données pour lire les données de courant de la partie entrée du courant (3) à des intervalles ayant un premier temps prédéterminé ou plus long et, lorsque ladite donnée de courant est comprise dans une gamme prédéterminée et en outre reste dans cette gamme pendant une période de temps qui est égale ou supérieure à un deuxième temps prédéterminé plus court que ledit premier tempe prédéterminé, pour lire tant la donnée de tension de ladite partie entrée de la tension (2) que la donnée de température de ladite partie entrée de la température (4), et pour lire la table de données (12) correspondant à une gamme de températures incluant ladite donnée de température, et une fonction de commande d'affichage de la tension pour obtenir le nombre de niveaux correspondant à la gamme de courants incluant la donnée de courant et à la donnée de tension sur la base de ces données et, lorsque ledit nombre diffère du nombre obtenu lors du traitement précédent de deux niveaux ou plus, pour compresser la différence par rapport au nombre précédent en un seul niveau, et afficher la capacité résiduelle ainsi actualisée correspondant au nombre de niveaux au moyen de la partie indicateur de mesure (5).
